(19) Europäisches Patentamt
European Patent Office
Office européen des brevets

(11) **EP 2 678 863 B1**

(12) **EUROPÄISCHE PATENTSCHRIFT**

(45) Veröffentlichungstag und Bekanntmachung des Hinweises auf die Patenterteilung:
**29.04.2015 Patentblatt 2015/18**

(21) Anmeldenummer: **12715572.9**

(22) Anmeldetag: **03.02.2012**

(51) Int Cl.:
***G11C 13/00*** *(2006.01)*

(86) Internationale Anmeldenummer:
**PCT/DE2012/000096**

(87) Internationale Veröffentlichungsnummer:
**WO 2012/113365 (30.08.2012 Gazette 2012/35)**

(54) **VERFAHREN ZUM NICHTDESTRUKTIVEN AUSLESEN RESISTIVER SPEICHERELEMENTE**

METHOD FOR NONDESTRUCTIVELY READING RESISTIVE MEMORY ELEMENTS

PROCÉDÉ DE LECTURE NON DESTRUCTIVE D'ÉLÉMENTS DE MÉMOIRE RÉSISTIFS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.02.2011 DE 102011012738**

(43) Veröffentlichungstag der Anmeldung:
**01.01.2014 Patentblatt 2014/01**

(73) Patentinhaber:
• **Forschungszentrum Jülich GmbH
52425 Jülich (DE)**
• **Rheinisch-Westfälische Technische Hochschule (RWTH) Aachen
52056 Aachen (DE)**

(72) Erfinder:
• **ROSEZIN, Roland, Daniel
83233 Bernau am Chiemsee (DE)**
• **LENTZ, Florian
50259 Pulheim (DE)**
• **BRUCHHAUS, Rainer
80639 München (DE)**
• **LINN, Eike
52074 Aachen (DE)**
• **VALOV, Ilia
52066 Aachen (DE)**
• **WASER, Rainer
52076 Aachen (DE)**
• **TAPPERTZHOFEN, Stefan
52064 Aachen (DE)**
• **NIELEN, Lutz
52064 Aachen (DE)**

(56) Entgegenhaltungen:
**JP-A- 7 014 380     US-A- 5 729 488**

• **MUSTAFA J ET AL: "Capacitive-resistive nondriven plateline cell architecture for RRAM technology", AEU INTERNATIONAL JOURNAL OF ELECTRONICS AND COMMUNICATIONS, ELSEVIER, JENA, DE, Bd. 60, Nr. 6, 1. Juni 2006 (2006-06-01), Seiten 459-461, XP028043128, ISSN: 1434-8411, DOI: 10.1016/J.AEUE.2005.09.005 [gefunden am 2006-06-01]**
• **CARSTEN KÃ 1/4 GELER ET AL: "Materials, technologies, and circuit concepts forÂ nanocrossbar-based bipolar RRAM", APPLIED PHYSICS A; MATERIALS SCIENCE & PROCESSING, SPRINGER, BERLIN, DE, Bd. 102, Nr. 4, 29. Januar 2011 (2011-01-29), Seiten 791-809, XP019890023, ISSN: 1432-0630, DOI: 10.1007/S00339-011-6287-2**

**EP 2 678 863 B1**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zum nichtdestruktiven Auslesen resistiver Speicherelemente.

Stand der Technik

Resistive Speicher zeichnen sich dadurch aus, dass sie sehr einfach aufgebaut sind. Dadurch können sie bei gegebener minimaler Featuregröße F auf einer Fläche von $4F^2$ realisiert werden. Herkömmliche resistive Speicherzellen haben einen stabilen Zustand 0 mit höherem elektrischem Widerstand und einen stabilen Zustand 1 mit geringerem elektrischem Widerstand. Nachteilig bilden sich in einer Speichermatrix mit vielen dieser Speicherzellen neben dem direkten Strompfad durch die jeweils adressierte Speicherzelle parasitäre Strompfade durch weitere Speicherzellen. Die Konfiguration dieser parasitären Strompfade ist zudem vom in der Speichermatrix gespeicherten Bitmuster abhängig.

Aus der DE 10 2009 023 153 ist ein Speicherelement bekannt, das eine Serienschaltung einer Speicherzelle A mit stabilen Zuständen A0 bzw. A1 und einer Speicherzelle B mit stabilen Zuständen B0 bzw. B1 aufweist. In diesem Speicherelement lässt sich der Zustand 0 in der Kombination der Zustände A1 und B0 kodieren, und der Zustand 1 lässt sich in der Kombination der Zustände A0 und B1 kodieren. Sowohl im Zustand 0 als auch im Zustand 1 ist dieses Speicherelement hochohmig, so dass es in jedem parasitären Strompfad als hochohmiger Widerstand fungiert. Mit diesen Speicherelementen lassen sich deutlich größere Speichermatrizen realisieren als mit herkömmlichen Speicherzellen.

Dieser Vorzug wird damit erkauft, dass nach dem Auslesen eines Zustandes 1 die Speicherzelle A in den Zustand A1 und die Speicherzelle B in den Zustand B0 geschaltet wird und somit die eingeschriebene Information verloren geht. Aus diesem Zustand kehrt das Speicherelement nicht wieder von selbst in den Zustand zurück, der vor dem Auslesen vorgelegen hat. Das Auslesen eines Zustandes 1 ist somit destruktiv. Um den Urzustand wieder herzustellen, muss der Zustand 1 erneut in das Speicherelement geschrieben werden.

Aus der US 5,729,488 A ist ein Verfahren zum nichtdestruktiven Auslesen eines Speicherelements bekannt, welches eine Verschaltung von mindestens zwei ferroelektrischen Kondensatorzellen A und B aufweist. Diese Zellen weisen jeweils einen stabilen Zustand A0 bzw. B0 mit höherer Nullfeldkapazität und einen stabilen Zustand A1 bzw. B1 mit geringerer Nullfeldkapazität auf. Der Zustand 0 des Speicherelements ist in der Kombination der Zustände A1 und B0 kodiert, und der Zustand 1 des Speicherelements ist in der Kombination der Zustände A0 und B1 kodiert. Beide Speicherzellen A und B sind in dem Speicherelement parallel geschaltet. Zum Auslesen des Speicherelements wird das Vorzeichen der Differenz zwischen den Kapazitäten der Speicherzellen A und B gemessen.

Aufgabe und Lösung

Es ist daher die Aufgabe der Erfindung, ein Verfahren zur Verfügung zu stellen, mit dem Speicherelemente der in DE 10 2009 023 153 beschriebenen Art nichtdestruktiv ausgelesen werden können. Es ist eine weitere Aufgabe der Erfindung, ein Speicherelement zur Verfügung zu stellen, das sich in besonderem Maße für die Durchführung dieses Verfahrens eignet.

Diese Aufgaben werden erfindungsgemäß gelöst durch ein Verfahren gemäß unabhängigen Anspruch 1 sowie durch ein Speicherelement gemäß unabhängigem Anspruch 8. Weiter vorteilhafte Ausgestaltungen ergeben sich jeweils aus den darau rückbezogenen Unteransprüchen.

Gegenstand der Erfindung

Im Rahmen der Erfindung wurde ein Verfahren zum Auslesen eines Speicherelements, welches eine Serienschaltung von mindestens zwei Speicherzellen A und B aufweist, entwickelt. Dabei haben die Speicherzellen A und B jeweils einen stabilen Zustand A0 bzw. B0 mit höherem Widerstand und einen stabilen Zustand A1 bzw. B1 mit geringerem elektrischem Widerstand. Der Zustand 0 des Speicherelements ist in der Kombination der Zustände A1 und B0 kodiert; der Zustand 1 des Speicherelements ist in der Kombination der Zustände A0 und B1 kodiert. Bei dem Verfahren wird eine elektrische Größe der Reihenschaltung gemessen.

Erfindungsgemäß wird für diese Messung eine elektrische Größe gewählt, zu der die Speicherzelle A im Zustand A0 einen anderen Beitrag leistet als die Speicherzelle B im Zustand B0 und/oder zu der die Speicherzelle A im Zustand A1 einen anderen Beitrag leistet als die Speicherzelle B im Zustand B1.

Es wurde erkannt, dass die beiden Zustandskombinationen A1 und B0 bzw. A0 und B1 dann zu unterschiedlichen Werten für die über die Reihenschaltung gemessene elektrische Größe führen. Somit können durch diese Messung die Zustände 0 und 1 des Speicherelements voneinander unterschieden werden, ohne dass das Speicherelement insgesamt in seinem Zustand verändert werden muss.

In einer besonders vorteilhaften Ausgestaltung des Verfahrens wird somit während des Auslesens keine der Speicherzellen in einen anderen Zustand umgeschaltet. Das Auslesen ist dann nichtdestruktiv. Somit wird die zusätzliche Zeit und Energie eingespart, die gemäß dem bisherigen Stand der Technik nach dem Auslesen eines Zustandes 1 benötigt wurde, um die ausgelesene 1 erneut in das Speicherelement zu schreiben. Des Weiteren wird die Lebensdauer des Speicherelements vorteilhaft erhöht. Auf der mikroskopischen Ebene ist das Umschalten der Speicherzellen nicht vollständig reversibel, so dass die Speicherzellen mit zunehmender Anzahl der Schreibzyklen progressiv degradieren. Indem das Lesen nun nichtdestruktiv ist, werden Schreibzyklen eingespart. Speicherelemente werden in aller Regel sehr viel häufiger gelesen als geschrieben, so dass sie durch das erfindungsgemäße Verfahren sehr viel länger einsetzbar sind.

In einer besonders vorteilhaften Ausgestaltung der Erfindung wird eine vom Speicherelement erzeugte Spannung als elektrische Größe gewählt, die gemessen wird. Es wurde erkannt, dass es Klassen von Speicherzellen gibt, die im Zustand hohen elektrischen Widerstands eine geringe elektrochemische Spannung erzeugen.

Eine solche Klasse umfasst Speicherzellen mit zwei Elektroden aus unterschiedlichen Metallen, wie beispielsweise Cu und Pt, zwischen denen ein Elektrolyt, wie beispielsweise GeSe oder Methylsilsesquioxan MSQ, angeordnet ist. Da die Metalle unterschiedliche Redoxpotentiale haben, hat ein Material eine stärkere Tendenz, Ionen in den Elektrolyten abzugeben, als das andere. Dies bewirkt einen Potentialunterschied und damit eine Spannung zwischen den beiden Elektroden.

Eine weitere Klasse umfasst Speicherzellen mit zwei metallischen Elektroden und einem dazwischen angeordneten Elektrolyten, wobei der Elektrolyt an den Grenzflächen zu den beiden Elektroden unterschiedliche Ionenkonzentrationen aufweist. Beispielsweise kann die Ionenkonzentration, etwa die Konzentration an Sauerstoffionen, im Elektrolyten einen Gradienten von der einen Elektrode zur anderen Elektrode aufweisen. Selbst wenn die Metalle der beiden Elektroden gleich sind, haben sie dann unterschiedliche Tendenzen, Ionen in den Elektrolyten abzugeben. Somit entsteht auch bei diesen Speicherzellen ein Potentialunterschied zwischen beiden Elektroden, der als Spannung messbar ist.

Typische Werte für die Spannung, die von einer Speicherzelle erzeugt wird, liegen um 50 mV.

Diese Spannung ist jedoch jeweils nur messbar, wenn sich die Speicherzelle im hochohmigen Zustand (A0 bzw. B0) befindet. Befindet sie sich im niederohmigen Zustand (A1 bzw. B1), wird der Potentialunterschied durch die Speicherzelle selbst überbrückt, so dass sie keinen messbaren Beitrag mehr zu der Spannung liefert, die insgesamt im Speicherelement erzeugt wird. Diese Überbrückung wird nach den Erkenntnissen der Erfinder durch mikroskopische elektronisch leitfähige Pfade bewirkt, die beim Umschalten in den Zustand A1 bzw. B1 durch den Elektrolyten hindurch gebildet werden. Unter widrigen Umgebungsbedingungen, wie etwa hoher Temperatur, kann ein solcher Pfad spontan abreißen. Dann schaltet die Speicherzelle in den Zustand A0 bzw. B0 um, und zugleich kehrt die Potentialdifferenz zwischen den beiden Elektroden zurück.

Wird der Potentialunterschied durch die Speicherzelle selbst überbrückt, fließt kein Strom, so dass die Speicherzelle auch nicht elektrochemisch verändert wird. Wird dagegen die Speicherzelle extern überbrückt, werden wie in einer Batterie Elektronen durch den externen Verbraucher transportiert, während in der Speicherzelle selbst Ionen transportiert werden. Dadurch werden die Elektrodenmaterialien in der Speicherzelle elektrochemisch degradiert. Es nimmt dann mit der Zeit nicht nur die von der Speicherzelle erzeugte Spannung ab, sondern die Speicherzelle verliert progressiv auch ihre primäre Funktion.

Erzeugen die beiden Speicherzellen A und B nun beispielsweise in ihren Zuständen A0 und B0 unterschiedliche Spannungen, lässt sich durch Messung der in der Reihenschaltung aus den Speicherzellen A und B erzeugten Spannung feststellen, ob sich die Speicherzelle A im Zustand A0 befindet oder ob sich die Speicherzelle B im Zustand B0 befindet. Dazu müssen die Speicherzellen A und B nicht einmal in unterschiedlicher Weise gefertigt werden. Sofern sie antiseriell verschaltet sind, speisen sie im Zustand A0 bzw. B0 ihre Spannungen mit unterschiedlichen Polaritäten in die Reihenschaltung ein. Die Polarität der am Speicherelement gemessenen Spannung liefert dann die Information, welche der Speicherzellen hochohmig ist. Entsprechend dem Funktionsprinzip des Speicherelements liegt hierdurch fest, in welchem der beiden Zustände 0 oder 1 sich das Speicherelement befindet.

In einer weiteren besonders vorteilhaften Ausgestaltung der Erfindung wird die Kapazität des Speicherelements als elektrische Größe gewählt, die gemessen wird. Es wurde erkannt, dass die Speicherzellen A und B so hergestellt werden können, dass sie sich zwar hinsichtlich ihres resistiven Schaltverhaltens gleichen, jedoch unterschiedliche Kapazitäten aufweisen. Speziell bei antiserieller Verschaltung zweier solcher Speicherzellen A und B bleibt die I-U-Kennlinie des aus diesen Speicherzellen zusammengesetzten Speicherelements symmetrisch, während die beiden Speicherzellen A und B durch ihre unterschiedlichen Beiträge zur Gesamtkapazität des Speicherelements voneinander unterschieden werden können.

Wie die von einer Speicherzelle erzeugte Spannung ist auch ihre Kapazität nur im hochohmigen Zustand A0 bzw. B0 in nennenswertem Umfang wirksam. Im niederohmigen Zustand (A1 bzw. B1) existieren mikroskopische, elektronisch leitfähige Pfade (Filamente) zwischen den beiden Elektroden der Speicherzelle, die als Kondensatorplatten die Kapazität bilden. In jedem der beiden Zustände 0 oder 1 des Speicherelements ist somit jeweils nur die Kapazität einer der beiden Speicherzellen (A oder B) für die gemessene Gesamtkapazität des Speicherelements maßgeblich.

Zur Messung der Kapazität wird vorteilhaft die Zeitkonstante ausgewertet, mit der die Gesamtkapazität des Speicherelements ge- oder entladen wird. Dazu werden Gesamtkapazität C und Gesamtwiderstand R des Speicherelements als RC-Kreis betrachtet. Dessen Zeitkonstante enthält nur das Produkt aus R und C. Haben die beiden Speicherzellen A und B, die das Speicherelement bilden, nominell gleiche Widerstandswerte, hat das Speicherelement insgesamt sowohl in seinem Zustand 0 als auch in seinem Zustand 1 den gleichen bekannten Gesamtwiderstand R, denn dieser setzt sich in beiden Zuständen zusammen aus einer hochohmigen und einer niederohmigen Speicherzelle.

Die Zeitkonstante kann beispielsweise ausgewertet werden, indem die Stromantwort beim Anlegen einer Gleichspannung an das Speicherelement untersucht wird. Dazu wird der Zeitverlauf des Stroms, der nach dem Anlegen einer Gleichspannung an das Speicherelement durch das Speicherelement getrieben wird, gemessen, beispielsweise als Spannungsabfall an einem mit dem Speicherelement in Reihe geschalteten Widerstand. Der Strom hängt vom Ladungszustand der Gesamtkapazität des Speicherelements ab. Er ist nach dem Einschalten der Gleichspannung zunächst hoch und klingt exponentiell mit der Zeitkonstanten des RC-Kreises auf einen konstanten Wert ab, der durch den Widerstand des Speicherelements bestimmt ist. Dieser Widerstand ist sowohl im Zustand 0 als auch im Zustand 1 des Speicherelements grundsätzlich hochohmig.

Die beiden Speicherzellen A und B des Speicherelements können jeweils als Parallelschaltung aus dem Widerstand und der Kapazität der jeweiligen Speicherzelle gesehen werden. Da der Widerstand der Speicherzelle durch das aktive Material zwischen den Elektroden bereitgestellt wird, welches als Dielektrikum des Kondensators fungiert, wirkt er nicht als Ladewiderstand für die Kapazität der Speicherzelle. Ladung kann auf den Elektroden deponiert werden, ohne das aktive Material passieren zu müssen. Vielmehr wirkt das aktive Material als Entladewiderstand der Kapazität. Je niedriger dieser Widerstand ist, desto schneller fließen Elektronen von der negativeren Elektrode durch das aktive Material hindurch zur positiveren Elektrode und gleichen die Potentialdifferenz zwischen beiden Elektroden aus. Hat die Speicherzelle im Zustand A1 bzw. B1 einen hinreichend kleinen Widerstand, sammeln sich auf den Elektroden der Speicherzelle keine Ladungen mehr an, sondern werden unmittelbar durch das aktive Material von der einen Elektrode zur anderen transportiert. Die Kapazität der im Zustand A1 bzw. B1 befindlichen Speicherzelle ist dann faktisch nicht mehr wirksam, so dass die Gesamtkapazität des Speicherelements durch die jeweils andere Speicherzelle, die sich im Zustand B0 bzw. A0 befindet, bestimmt ist.

Da in jedem Speicherelement immer eine der Speicherzellen A oder B im Zustand A0 bzw. B0 ist, ist immer die Kapazität einer der beiden Speicherzellen wirksam. In einer Speichermatrix aus vielen Speicherzellen wirken daher die Kapazitäten der nicht adressierten Speicherelemente als parasitäre Kapazitäten und verringern mit zunehmender Anzahl der Speicherelemente die Genauigkeit der Messung.

In einer weiteren besonders vorteilhaften Ausgestaltung der Erfindung wird der Zeitverlauf des Potentials gemessen, das nach dem Anlegen einer Gleichspannung an eine Reihenschaltung aus dem Speicherelement und einer weiteren Kapazität zwischen dem Speicherelement und der weiteren Kapazität herrscht.

Es wurde erkannt, dass das Speicherelement und die weitere Kapazität dann einen kapazitiven Spannungsteiler bilden. Welches Potential sich am Abgriffspunkt zwischen dem Speicherelement und der weiteren Kapazität einstellt, hängt von der Kapazität des Speicherelements ab. Nach dem zuvor Gesagten ist diese Kapazität je nach Zustand des Speicherelements (0 oder 1) bestimmt durch die Kapazität einer der beiden Speicherzellen A oder B, weil die Kapazität der niederohmigen Speicherzelle faktisch nicht wirksam ist. Damit hängt das gemessene Potential davon ab, in welchem Zustand sich das Speicherelement befindet.

Es wurde erkannt, dass hierbei der Durchgriff der Kapazitäten nicht adressierter Speicherzellen auf das gemessene Potential umso geringer ist, je größer die weitere Kapazität ist. Die weitere Kapazität drängt den Einfluss nicht adressierter Speicherelemente zurück. Die kritische Größe einer Speichermatrix, ab der das durch das adressierte Speicherelement bewirkte Potential nicht mehr sicher vom durch nicht adressierte Speicherelemente bewirkten Potential unterschieden werden kann, kann somit durch die Erhöhung der weiteren Kapazität gesteigert werden. Auf der anderen Seite nimmt mit steigender weiterer Kapazität aber auch der Betrag (Voltage-Swing) ab, um den sich das gemessene Potential zwischen den Zuständen 0 und 1 des Speicherelements unterscheidet.

Die weitere Kapazität kann eine externe Kapazität sein, die mit dem Speicherelement in Reihe geschaltet wird und beispielsweise zwischen eine Bitline und Masse geschaltet ist. Je nach Schaltungsaufbau einer Speichermatrix, in der das Speicherelement enthalten ist, können aber auch die ohnehin vorhandenen Kapazitäten, etwa die Kapazitäten metallischer Leitungen, als weitere Kapazität fungieren und den Beitrag nicht adressierter Speicherelemente unterdrücken.

Da das Speicherelement nur über die Reihenschaltung mit der weiteren Kapazität mit Masse verbunden ist, wird es nach dem Anlegen der Gleichspannung nicht ständig von einem Strom durchflossen. Durch das Speicherelement kann nur diejenige Ladungsmenge fließen, die erforderlich ist, um die weitere Kapazität voll aufzuladen. Danach sperrt diese weitere Kapazität den weiteren Stromfluss in Richtung Masse. Mit dem Stromfluss verschwindet aber auch der Spannungsabfall über den beiden Speicherzellen des Speicherelements; dieser war durch den Stromfluss durch das resistive aktive Material bewirkt worden. Somit geht der Abgriffspunkt, an dem das Potential gemessen wird, auf die Versorgungsspannung, sobald die weitere Kapazität voll aufgeladen ist. Somit kann der Zustand des Speicherelements über das Potential zwischen Speicherelement und weiterer Kapazität nur ausgelesen werden, während diese weitere Kapazität aufgeladen wird. Die Zeit, die hierfür zur Verfügung steht, ist durch die Größe der weiteren Kapazität und den durch das Speicherelement getriebenen Strom bestimmt.

Der Schaltungsaufbau, in dem das Speicherelement nur über die Reihenschaltung mit der weiteren Kapazität mit Masse verbunden ist, eignet sich in aller Regel nur zum Auslesen des Speicherelements. Um den Zustand des Speicherelements umzuschalten, muss nicht nur eine Schreibspannung angelegt werden, sondern es muss auch über eine ausreichende Zeitdauer ein Strom durch das Speicherelement getrieben werden. Dazu muss entweder die weitere Kapazität sehr groß sein, oder das Speicherelement muss ohne zwischengeschaltete weitere Kapazität mit Masse verbunden sein.

Alternativ oder auch in Kombination zu den Kapazitätsmessungen durch Anlegen einer Gleichspannung kann der Abfall einer Wechselspannung über dem Speicherelement gemessen werden. Das Speicherelement bildet dann hinsichtlich des Wechselstromwiderstands zusammen mit den inhärent vorhandenen parasitären Kapazitäten einen kapazitiven Spannungsteiler. Die Messung mit Wechselspannung bietet den Vorteil, dass der Spannungsabfall ständig vorhanden ist und nicht kurze Zeit nach dem Anlegen der Spannung verschwindet.

Wie stark sich die Kapazitäten der Speicherzellen A und B voneinander unterscheiden, wird bei deren Herstellung durch ihre Geometrie festgelegt. Die Speicherzellen sind in erster Näherung Plattenkondensatoren, deren Platten die metallischen Elektroden sind und deren Dielektrikum durch das aktive Speichermedium gebildet wird. Die Erfindung bezieht sich daher auch auf ein Speicherelement mit mindestens einem ersten stabilen Zustand 0 und einem zweiten stabilen Zustand 1, welches durch Anlegen einer ersten Schreibspannung $V_0$ in den Zustand 0 und durch Anlegen einer zweiten Schreibspannung $V_1$ in den Zustand 1 überführbar ist, wobei die beiden Zustände 0 und 1 sich bei Anlegen einer Auslesespannung $V_R$, welche betragsmäßig kleiner ist als die Schreibspannungen $V_0$ und $V_1$, in unterschiedlichen elektrischen Widerstandswerten des Speicherelements manifestieren. Dabei weist das Speicherelement eine Serienschaltung von mindestens zwei Speicherzellen A und B auf, welche jeweils einen stabilen Zustand A0 bzw. B0 mit höherem elektrischem Widerstand und einen stabilen Zustand A1 bzw. B1 mit geringerem elektrischem Widerstand aufweisen. Erfindungsgemäß unterscheiden sich die Kapazitäten der Speicherzellen A und B in der Zustandskombination A0 und B0 und/oder in der Zustandskombination A1 und B1 um mindestens 10 %, bevorzugt um mindestens 15 % und ganz besonders bevorzugt um mindestens 20 %.

Ein solches Speicherelement bietet nach dem zuvor Gesagten den Vorzug, dass sich durch eine Messung der Gesamtkapazität feststellen lässt, welche der beiden Speicherzellen sich im Zustand A1 bzw. B1 befindet. Ist nun der Zustand 0 des Speicherelements in der Kombination der Zustände A1 und B0 kodiert und ist der Zustand 1 des Speicherelements in der Kombination der Zustände A0 und B1 kodiert, lässt sich somit durch Messung der Gesamtkapazität feststellen, ob sich das Speicherelement im Zustand 0 oder im Zustand 1 befindet.

Für die Realisierung einer Speichermatrix aus vielen Speicherelementen ist es wünschenswert, dass die Kapazität eines einzelnen Speicherelements in beiden Zuständen 0 und 1 jeweils gering ist. Die erfindungsgemäß vorgesehene weitere Kapazität vermag den Einfluss nicht adressierter Speicherelemente nur dann zuverlässig zu unterdrücken, wenn die weitere Kapazität groß gegen die Gesamtkapazität aller parasitären Strompfade durch nicht adressierte Speicherelemente ist. Alle zwischen einer gegebenen Wordline und einer gegebenen Bitline möglichen parasitären Strompfade sind parallel geschaltet, so dass sich ihre Kapazitäten addieren.

In einer besonders vorteilhaften Ausgestaltung der Erfindung ist das Speicherelement als Stapelung aus einer ersten metallischen Elektrode, einer ersten Schicht aktiven Materials mit veränderlichem elektrischem Widerstand, einer zweiten metallischen Elektrode, einer weiteren Schicht aktiven Materials mit veränderlichem elektrischem Widerstand und einer dritten metallischen Elektrode ausgebildet. Es lässt sich dann in erster Näherung als Plattenkondensator betrachten, wobei die Elektroden als Platten fungieren und das aktive Material das Dielektrikum bildet.

Vorteilhaft unterscheiden sich die beiden Schichten aktiven Materials in ihren Dicken um mindestens einen Faktor 1,1, bevorzugt um mindestens einen Faktor 1,5 und ganz besonders bevorzugt um mindestens einen Faktor 2. Beispielhaft wurde ein Speicherelement als Stapelung aus einer Pt-Elektrode, einer Schicht $SiO_2$ als aktives Material der Speicherzelle A, einer Cu-Elektrode als gemeinsamer Elektrode beider Speicherzellen A und B, einer weiteren Schicht $SiO_2$ als aktives Material der Speicherzelle B und einer weiteren Pt-Elektrode realisiert. Dabei hatte die erste $SiO_2$-Schicht eine Dicke von 10 nm, und die zweite $SiO_2$-Schicht hatte eine Dicke von 20 nm. Damit hatte die Speicherzelle B die doppelte Kapazität der Speicherzelle A.

Vorteilhaft unterscheiden sich die beiden Schichten aktiven Materials in ihren Dielektrizitätskonstanten um mindestens einen Faktor 1,1, bevorzugt um mindestens einen Faktor 2 und ganz besonders bevorzugt um mindestens einen Faktor 5. Beispielhaft wurde ein Speicherelement als Stapelung aus einer Pt-Elektrode, einer Schicht $SiO_2$ als aktives Material der Speicherzelle A, einer Cu-Elektrode als gemeinsamer Elektrode beider Speicherzellen A und B, einer Schicht $TiO_2$ als aktives Material der Speicherzelle B und einer weiteren Pt-Elektrode realisiert. Die relative Dielektrizitätskonstante $\varepsilon_r$ von $SiO_2$ beträgt 4, die relative Dielektrizitätskonstante $\varepsilon_r$ von $TiO_2$ beträgt 20. Speicherzelle B hatte somit die fünffache Kapazität von Speicherzelle A.

Soll eine vom Speicherelement erzeugte Spannung als elektrische Größe gemessen werden, um das Speicherelement zerstörungsfrei auszulesen, und umfasst das Speicherelement Speicherzellen mit zwei Elektroden aus unterschiedlichen Metallen, zwischen denen ein Elektrolyt angeordnet ist, so lässt sich durch geeignete Auswahl der verwendeten Materialien als Elektroden und Elektrolyt die Spannung maximieren. Bei dieser Bauart der Speicherzellen kommt es darauf an, dass die Metalle der beiden Elektroden einer Speicherzelle in der elektrochemischen Spannungsreihe möglichst weit auseinander liegen. Zugleich ist jedoch auch erforderlich, dass mindestens eines der Metalle in Form von Ionen im Elektrolyten mobil ist, damit diese Ionen einen elektronisch leitenden Pfad durch den Elektrolyten bilden können. Das Umschalten der Speicherzelle in den Zustand A1 bzw. B1 mit geringerem elektrischem Widerstand wird durch die Ausbildung ebendieses Pfades bewirkt.

In den Versuchen der Erfinder haben sich Kupfer und Silber als Elektrodenmetalle bewährt, deren Ionen im Elektrolyten mobil sind und die jeweils in Verbindung mit einem deutlich edleren oder deutlich unedleren Metall als zweiter Elektrode eine gut messbare Spannung erzeugen. Silber, Platin und Wolfram sind in diesem Zusammenhang besonders geeignete Metalle für die zweite Elektrode. Vorteilhaft ist der Elektrolyt ein Chalkogenid. Selenide, Sulfide und Oxide zählen zu den Chalkogeniden.

Spezieller Beschreibungsteil

Nachfolgend wird der Erfindungsgegenstand anhand von Figuren erläutert, ohne dass der Gegenstand der Erfindung dadurch beschränkt wird. Es ist gezeigt:

Figur 1: Schaltungsaufbau für das nichtdestruktive Auslesen eines Speicherelements über die Stromantwort mit Ersatzschaltbildern des Speicherelements im Zustand 1 und Zustand 0.

Figur 2: Unterschied in den Stromantworten, der für die in den Figuren 1a und 1b gezeigten Zustände 1 und 0 des Speicherelements erhalten wird.

Figur 3: Schaltungsaufbau für das nichtdestruktive Auslesen eines Speicherelements über einen kapazitiven Spannungsteiler mit einer weiteren Kapazität $C_{out}$.

Figur 4: Zeitverlauf der im Schaltungsaufbau gemäß Figur 3 gemessen Spannung $V_{mess}$ für die Zustände 0 und 1 des Speicherelements innerhalb der ersten 10 ns nach dem Anlegen der Gleichspannung.

Figur 5: Gesamtdarstellung des Verlaufs von $V_{mess}$ im Schaltungsaufbau gemäß Figur 3 vom Anlegen der Gleichspannung bis zum Ende des Einschwingvorgangs.

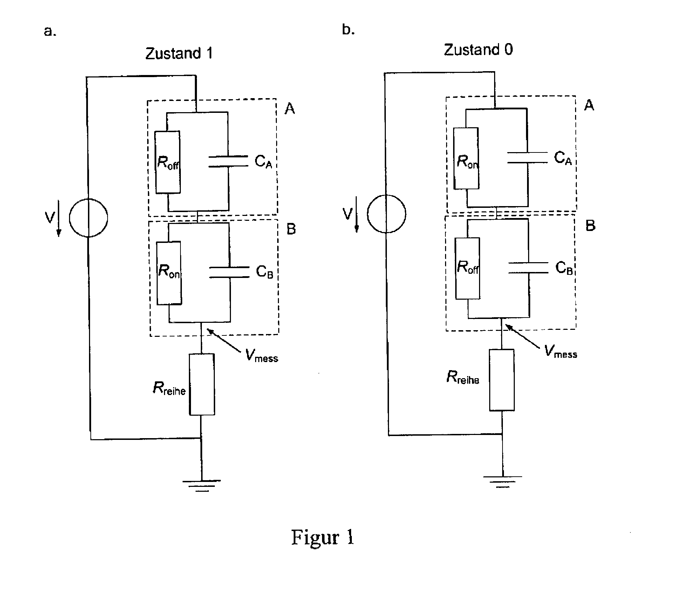

Figur 1 zeigt den Schaltungsaufbau, mit dem sich ein Speicherelement aus zwei Speicherzellen unterschiedlicher Kapazitäten über die Stromantwort auslesen lässt. In Teilbild a ist das Speicherelement im Zustand 1 (Zustandskombination A0 und B1 in den Speicherzellen). In Teilbild b ist das Speicherelement im Zustand 0 (Zustandskombination A1 und B0 in den Speicherzellen). Das Speicherelement ist jeweils als Ersatzschaltbild dargestellt. Jede der Speicherzellen A und B hat im Zustand A0 bzw. B0 einen Widerstand $R_{off}$ von 1 MΩ und im Zustand A1 bzw. B1 einen Widerstand $R_{on}$ von 1 kΩ. Dabei bilden die quadratischen Elektroden der Speicherzelle A mit 1 μm Kantenlänge und das zwischen ihnen angeordnete aktive Material mit einer Dicke von 30 nm und einer relativen Dielektrizitätskonstanten von 4, das den Widerstand der Speicherzelle A bereitstellt, eine Kapazität $C_A$ von 1,18 fF. Die Elektroden der Speicherzelle B und das zwischen ihnen angeordnete aktive Material, das den Widerstand der Speicherzelle B bereitstellt, bilden eine Kapazität $C_B$ von 11,8 fF. Mit dem Speicherelement ist ein Widerstand $R_{reihe}$ von 1 MΩ in Reihe geschaltet. Der durch das Speicherelement fließende Strom $I_1$ bzw. $I_0$ erzeugt an diesem Widerstand einen Spannungsabfall von $V_{mess}$ gegen Masse, der als Messsignal ausgewertet wird.

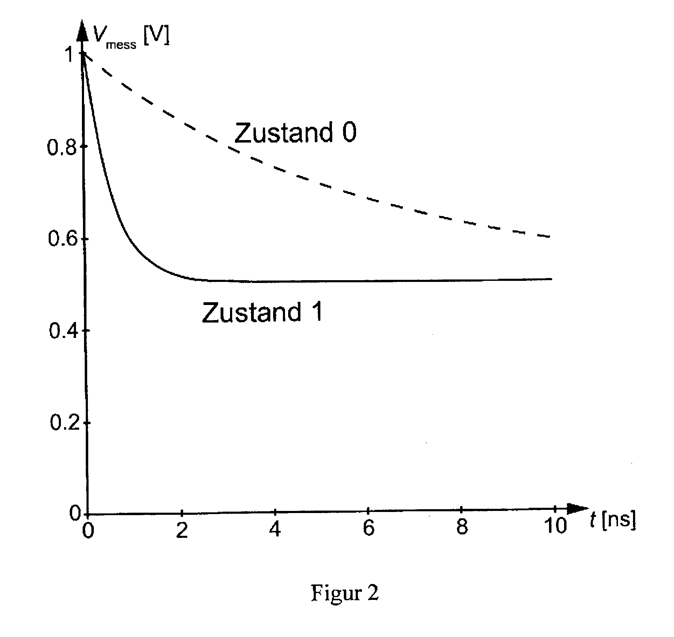

Figur 2 zeigt die Stromantworten für die in den Figuren 1a und 1b dargestellten Zustände des Speicherelements nach dem Anlegen einer Gleichspannung. Aufgetragen ist die an $R_{reihe}$ abfallende Spannung $V_{mess}$ über der Zeit t.

Im Zustand 1 ist die Speicherzelle B im Zustand B1, so dass ihre hohe Kapazität $C_B$ nicht wirksam ist. Maßgeblich für die Gesamtkapazität des Speicherelements ist die nur ein Zehntel so große Kapazität $C_A$. Dementsprechend schnell lädt sich das Speicherelement bis zu einem stationären Zustand auf, in dem sich Ladung und Entladung seiner Kapazität die Waage halten.

Im Zustand 0 ist die Speicherzelle A im Zustand A0, so dass lediglich die kleine Kapazität $C_A$ faktisch wegfällt. Die große Kapazität $C_B$ der Speicherzelle B ist dagegen wirksam. Sie benötigt eine erheblich größere Zeitkonstante, bis der stationäre Zustand erreicht ist.

Eine solche Messung kann mit beliebigen Werten für die an das Speicherelement angelegte Spannung durchgeführt werden. Die Spannung kann insbesondere betragsmäßig gering genug gewählt werden, dass keine der Speicherzellen in einen anderen Zustand umgeschaltet wird. Das Lesen ist dann nichtdestruktiv.

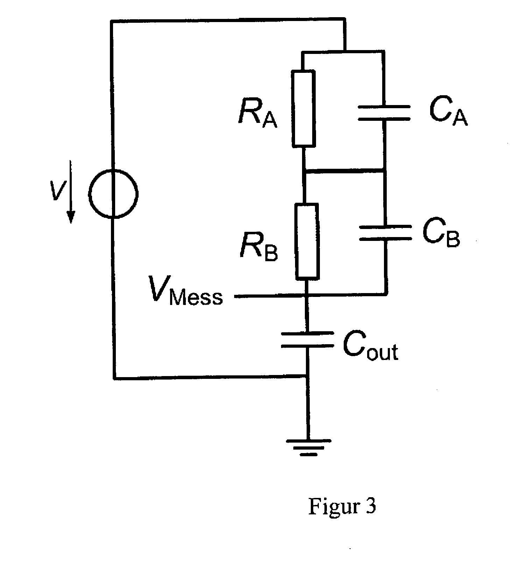

Figur 3 zeigt den Schaltungsaufbau, mit dem sich ein Speicherelement aus zwei Speicherzellen unterschiedlicher Kapazitäten über einen kapazitiven Spannungsteiler mit einer weiteren Kapazität $C_{out}$ auslesen lässt. Das Speicherelement ist als sein Ersatzschaltbild dargestellt. Hierin ist die Speicherzelle A eine Parallelschaltung aus ihrem Widerstand $R_A$ und ihrer Kapazität $C_A$. Die Speicherzelle B ist eine Parallelschaltung aus ihrem Widerstand $R_B$ und ihrer Kapazität $C_B$. Beide Speicherzellen A und B sind in Reihe geschaltet. Im Gegensatz zu Figur 1 ist das Speicherelement nun nicht über einen Widerstand $R_{reihe}$ mit Masse verbunden, sondern über eine weitere Kapazität $C_{out}$, die sich aus den ohnehin vorhandenen Kapazitäten des Schaltungsaufbaus außerhalb des Speicherelements und einer eventuellen externen Kapazität zusammensetzt. Eine Gleich- oder Wechselspannung gegen Masse kann über den Punkt V angelegt werden. Am Punkt $V_{mess}$ wird dann die Spannung gegen Masse gemessen.

Nach den Regeln der komplexen Wechselstromrechnung addieren sich die reziproken Wechselstromwiderstände von $R_A$ und $C_A$ bzw. $R_B$ und $C_B$ zum Wechselstromwiderstand der Speicherzelle A bzw. B. Die Wechselstromwiderstände beider Speicherzellen A und B sowie der weiteren Kapazität $C_{out}$ addieren sich zur Gesamtimpedanz der Schaltung. Damit ergibt sich für das Verhältnis von $V_{mess}$ zu V im eingeschwungenen Zustand

$$\frac{V_{mess}}{V} = \frac{1 - \dfrac{\omega^2 R_A^2 C_A C_{out}}{1-\left(\omega C_A R_A\right)^2} - \dfrac{\omega^2 R_B^2 C_B C_{out}}{1-\left(\omega C_B R_B\right)^2} + j\,\dfrac{\omega R_A C_{out}}{1-\left(\omega C_A R_A\right)^2} + \dfrac{\omega R_B C_{out}}{1-\left(\omega C_B R_B\right)^2}}{\left(1 - \dfrac{\omega^2 R_A^2 C_A C_{out}}{1-\left(\omega C_A R_A\right)^2} - \dfrac{\omega^2 R_B^2 C_B C_{out}}{1-\left(\omega C_B R_B\right)^2}\right)^2 - \left(\dfrac{\omega R_A C_{out}}{1-\left(\omega C_A R_A\right)^2} + \dfrac{\omega R_b C_{out}}{1-\left(\omega C_B R_B\right)^2}\right)^2}$$

Wird eine sehr hochfrequente Wechselspannung angelegt und berücksichtigt, dass gemäß der Funktion des Speicherelements immer einer der beiden Widerstände $R_A$ oder $R_B$ klein ist, vereinfacht sich obige Formel im Zustand 1 des Speicherelements (Zustandskombination A0 und B1 der Speicherzellen) zu

$$\frac{V_{mess}}{V} = \frac{1 + \dfrac{\omega^2 R_A^2 C_A C_{out}}{1-\left(\omega C_A R_A\right)^2}}{\left(1 + \dfrac{\omega^2 R_A^2 C_A C_{out}}{1-\left(\omega C_A R_A\right)^2}\right)^2} = \frac{1}{1 + \dfrac{\omega^2 R_A^2 C_A C_{out}}{1-\left(\omega C_A R_A\right)^2}} = \frac{1}{1 + \dfrac{C_{out}}{C_A}} = \frac{C_A}{C_A + C_{out}}$$

und im Zustand 0 des Speicherelements (Zustandskombination A1 und B0 der Speicherzellen) zu

$$\frac{V_{mess}}{V} = \frac{1 + \dfrac{\omega^2 R_B^2 C_B C_{out}}{1-\left(\omega C_B R_B\right)^2}}{\left(1 + \dfrac{\omega^2 R_B^2 C_B C_{out}}{1-\left(\omega C_B R_B\right)^2}\right)^2} = \frac{1}{1 + \dfrac{\omega^2 R_B^2 C_B C_{out}}{1-\left(\omega C_B R_B\right)^2}} = \frac{1}{1 + \dfrac{C_{out}}{C_B}} = \frac{C_B}{C_B + C_{out}}$$

Somit kann durch Anlegen einer hochfrequenten Wechselspannung auch dann zuverlässig zwischen den beiden Zuständen 0 und 1 des Speicherelements unterschieden werden, wenn ihr Betrag nicht ausreicht, um eine der beiden Speicherzellen A oder B umzuschalten. Anders als beim herkömmlichen Leseprozess für derartige Speicherelemente gibt es keine untere Grenze mehr für die nutzbare Lesespannung.

Wird dagegen eine Gleichspannung angelegt ($\omega=0$), geht im eingeschwungenen Zustand $V_{mess}$ auf die Betriebsspannung V. Während das System einschwingt und dabei den Zustand $V_{mess}=V$ anstrebt, ist die bei obiger Herleitung getroffenen Annahmen, dass alle Spannungen und Ströme sinusförmig sind, verletzt. Der Zeitverlauf des Einschwingvorgangs und damit auch des Verhältnisses $V_{mess}/V$ nach dem Einschalten der Gleichspannung lässt sich berechnen, indem die auf den Schaltungsaufbau angewendeten Kirchhoffschen Regeln in eine Differentialgleichung für $V_{mess}$ umgeformt werden. Alternativ kann näherungsweise der Zeitverlauf beim Einschalten als aperiodisches Signal betrachtet werden, das sich in unendlich viele Fourier-Komponenten zerlegen lässt, von denen die hochfrequenten den obigen Gleichungen genügen.

Somit unterscheidet sich für eine kurze Zeit nach dem Anlegen einer Gleichspannung $V_{mess}$ von V, was genutzt werden kann, um den Zustand des Speicherelements auszulesen.

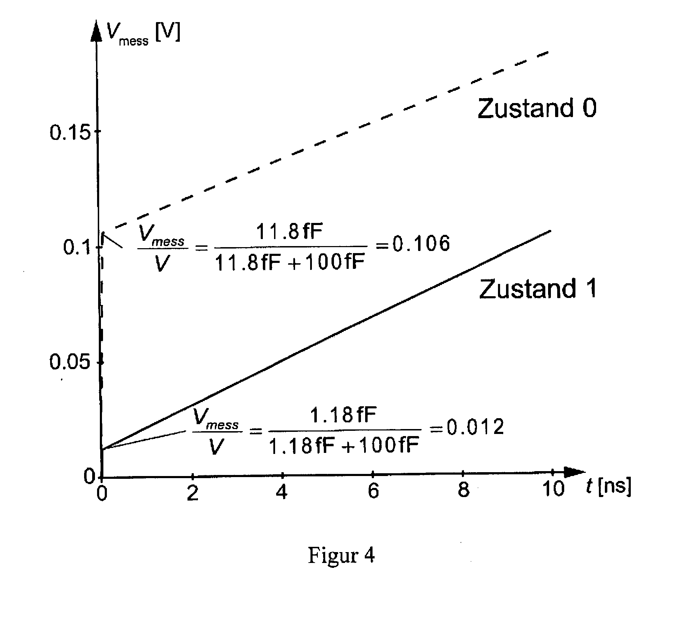

Figur 4 zeigt den Zeitverlauf der im Schaltungsaufbau gemäß Figur 3 gemessen Spannung $V_{mess}$ für die Zustände 0 und 1 des Speicherelements innerhalb der ersten 10 ns nach dem Anlegen der Gleichspannung. Die Speicherzellen haben die gleichen Kapazitäten $C_A$ und $C_B$ wie in dem in Figur 1 gezeigten Schaltungsaufbau. Die weitere Kapazität $C_{out}$ beträgt 100 fF.

Innerhalb der ersten 10 ns nach dem Anlegen der Gleichspannung unterscheiden sich die für beide Zustände gemessenen Spannungen um einen Faktor von 8,8, so dass diese Zustände leicht voneinander unterscheidbar sind. Da bei herkömmlichen DRAM-Speichermodulen Zugriffszeiten der Größenordnung 8 ns Stand der Technik sind, ist Ausleseelektronik, die eine Gleichspannung anzulegen und innerhalb von 10 ns $V_{mess}$ zu bestimmen vermag, jedenfalls verfügbar.

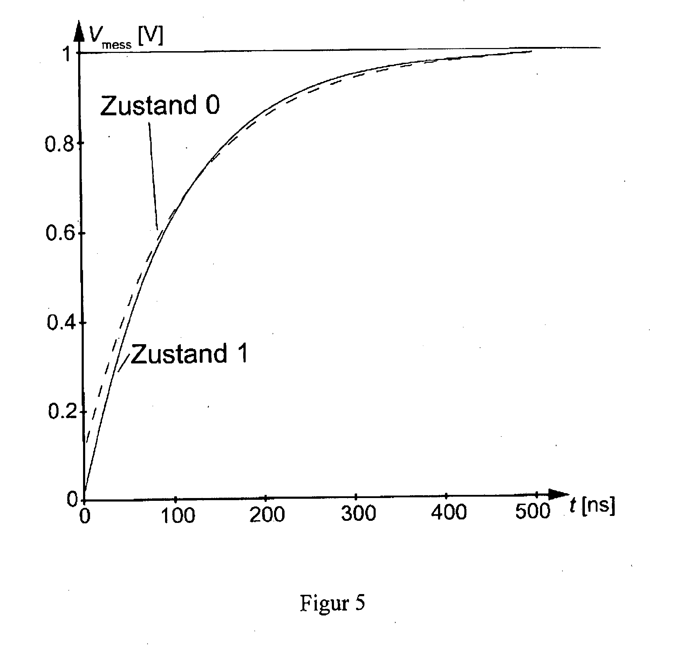

Figur 5 zeigt den weiteren Zeitverlauf der Spannung $V_{mess}$ bis 500 ns nach dem Anlegen der Gleichspannung. Zu diesem Zeitpunkt ist das System bereits fast eingeschwungen; für beide Zustände 0 und 1 des Speicherelements strebt die Spannung $V_{mess}$ die Versorgungsspannung an. Der Einschwingvorgang ist dadurch gekennzeichnet, dass bis etwa 120 ns nach dem Anlegen der Gleichspannung der Unterschied in der Spannung $V_{mess}$ zwischen den beiden Zuständen 0 und 1 stetig abnimmt und sich anschließend unter Vorzeichenwechsel erneut herausbildet. Der Unterschied ist dann aber selbst in seinem lokalen Maximum bei etwa 250 ns bei weitem nicht mehr so prägnant wie in den ersten 10 ns nach dem Anlegen der Gleichspannung. Jenseits dieses lokalen Maximums nimmt der Unterschied wieder stetig ab, bis er am Ende des Einschwingvorgangs völlig verschwindet.

Die Zeitverläufe von $V_{mess}$ wurden jeweils mit der Software SPICE simuliert.

In einem Array aus vielen Speicherelementen sind zusätzlich die parasitären Kapazitäten nicht adressierter Speicherelemente zu berücksichtigen. Die Größe dieser parasitären Kapazitäten sowie ihre Verteilung innerhalb des Arrays hängen von dem Bitmuster ab, das im Array gespeichert ist. Damit hängt auch die zur Verfügung stehende Zeit für das Auslesen von Zuständen vom Bitmuster ab. In der technischen Realisierung des Arrays richtet sich die Zeitspanne zwischen Anlegen der Gleichspannung und Messung von $V_{mess}$ daher nach dem diesbezüglich ungünstigsten denkbaren Bitmuster.

**Patentansprüche**

1. Verfahren zum Auslesen eines Speicherelements, welches eine Verschaltung von mindestens zwei Speicherzellen A und B aufweist, welche jeweils einen stabilen Zustand A0 bzw. B0 und einen stabilen Zustand A1 bzw. B1 aufweisen, wobei der Zustand 0 des Speicherelements in der Kombination der Zustände A1 und B0 kodiert ist und der Zustand 1 des Speicherelements in der Kombination der Zustände A0 und B1 kodiert ist, wobei während des Auslesens keine der Speicherzellen A und B in einen anderen Zustand umgeschaltet wird,
**dadurch gekennzeichnet, dass**

    • ein Speicherelement gewählt wird, welches eine antiserielle Verschaltung von mindestens zwei resistiven Speicherzellen A und B aufweist, welche jeweils einen stabilen Zustand A0 bzw. B0 mit höherem elektrischen Widerstand ($R_{off}$) und einen stabilen Zustand A1 bzw. B1 mit geringerem elektrischem Widerstand ($R_{on}$) aufweisen;
    • das Auslesen des Speicherelements durch Messung einer elektrischen Größe der antiseriellen Speicherzellenverschaltung erfolgt; und
    • hierfür eine elektrische Größe gewählt wird, zu der die Speicherzelle A im Zustand A0 einen anderen Beitrag leistet als die Speicherzelle B im Zustand B0 und/oder zu der die Speicherzelle A im Zustand A1 einen anderen Beitrag leistet als die Speicherzelle B im Zustand B1.

2. Verfahren nach Anspruch 1, **dadurch gekennzeichnet, dass** eine vom Speicherelement erzeugte elektrochemische Spannung als elektrische Größe gewählt wird.

3. Verfahren nach Anspruch 1, **dadurch gekennzeichnet, dass** die Kapazität des Speicherelements ($R_A$, $R_B$, $C_A$, $C_B$) als elektrische Größe gewählt wird.

4. Verfahren nach Anspruch 3, **dadurch gekennzeichnet, dass** die Zeitkonstante ausgewertet wird, mit der die Kapazität ge- oder entladen wird.

5. Verfahren nach einem der Ansprüche 3 bis 4, **dadurch gekennzeichnet, dass** der Zeitverlauf des Stroms ($V_{mess}/R_{reihe}$), der nach dem Anlegen einer Gleichspannung an das Speicherelement durch das Speicherelement getrieben wird, gemessen wird.

6. Verfahren nach einem der vorhergehenden Ansprüche 3 bis 5, **dadurch gekennzeichnet, dass** der Zeitverlauf des Potentials ($V_{mess}$) gemessen wird, das nach dem Anlegen einer Gleichspannung (V) an eine Reihenschaltung aus dem Speicherelement und einer weiteren Kapazität zwischen dem Speicherelement ($R_A$, $R_B$, $C_A$, $C_B$) und der weiteren Kapazität ($C_{out}$) herrscht.

7. Verfahren nach einem der vorhergehenden Ansprüche 3 bis 6, **dadurch gekennzeichnet, dass** der Abfall einer Wechselspannung über dem Speicherelement gemessen wird.

8. Speicherelement mit mindestens einem ersten stabilen Zustand 0 und einem zweiten stabilen Zustand 1, welches durch Anlegen einer ersten Schreibspannung $V_0$ in den Zustand 0 und durch Anlegen einer zweiten Schreibspannung $V_1$ in den Zustand 1 überführbar ist, wobei die beiden Zustände 0 und 1 sich bei Anlegen einer Auslesespannung $V_R$, welche betragsmäßig kleiner ist als die Schreibspannungen $V_0$ und $V_1$, in unterschiedlichen elektrischen Widerstandswerten des Speicherelements manifestieren, wobei das Speicherelement eine Verschaltung von mindestens zwei Speicherzellen A und B aufweist, welche jeweils einen stabilen Zustand A0 bzw. B0 und einen stabilen Zustand A1 bzw. B1 aufweisen,
**dadurch gekennzeichnet, dass**

• die Verschaltung eine antiserielle Verschaltung von mindestens zwei resistiven Speicherzellen A und B ist, welche jeweils einen stabilen Zustand A0 bzw. B0 mit höherem elektrischem Widerstand ($R_{off}$) und einen stabilen Zustand A1 bzw.
B1 mit geringerem elektrischem Widerstand ($R_{on}$) aufweisen; und
• die Kapazitäten der Speicherzellen A und B sich in der Zustandskombination A0 und B0 und/oder in der Zustandskombination A1 und B1 um mindestens 10 % unterscheiden.

9. Speicherelement nach Anspruch 8, **dadurch gekennzeichnet, dass** es als Stapelung aus einer ersten metallischen Elektrode, einer ersten Schicht aktiven Materials mit veränderlichem elektrischem Widerstand, einer zweiten metallischen Elektrode, einer weiteren Schicht aktiven Materials mit veränderlichem elektrischem Widerstand und einer dritten metallischen Elektrode ausgebildet ist.

10. Speicherelement nach Anspruch 9, **dadurch gekennzeichnet, dass** die beiden Schichten aktiven Materials sich in ihren Dicken um mindestens einen Faktor 1,1 unterscheiden.

11. Speicherelement nach einem der Ansprüche 9 bis 10, **dadurch gekennzeichnet, dass** die beiden Schichten aktiven Materials sich in ihren Dielektrizitätskonstanten um mindestens einen Faktor 1,1 unterscheiden.

**Claims**

1. Method for reading a memory element, which has a circuit of at least two memory cells A and B, each having a stable state A0 or B0 and a stable state A1 or B1, in which state 0 of the memory element is coded in the combination of states A1 and B0 and state 1 of the memory element is coded in the combination of states A0 and B1, in which none of the memory cells A and B is switched over to a different state during reading,
**characterised in that**

• a memory element is selected, which has an anti-series circuit of at least two resistive memory cells A and B, each having a stable state A0 or B0 with higher electrical resistance ($R_{off}$) and a stable state A1 or B1 with lower electrical resistance ($R_{on}$);
• the memory element is read by measuring an electrical value of the anti-series memory cell circuit; and
• an electrical value is selected for this, at which the memory cell A makes a different contribution in state A0 than the memory cell B in state B0 and/or the memory cell A makes a different contribution in state A1 than the memory cell B in state B1.

2. Method according to claim 1, **characterised in that** an electrochemical voltage produced by the memory element is selected as the electrical value.

3. Method according to claim 1, **characterised in that** the capacity of the memory element ($R_A$, $R_B$, $C_A$, $C_B$) is selected as the electrical value.

4. Method according to claim 3, **characterised in that** the time constant is evaluated, with which the capacity is loaded or discharged.

**5.** Method according to one of claims 3 to 4, **characterised in that** running time of the current ($V_{mess}$/$R_{reihe}$), which is driven through the memory element after applying a direct current voltage to the memory element, is measured.

**6.** Method according to one of previous claims 3 to 5, **characterised in that** the running time of the potential ($V_{mess}$) is measured, which prevails after applying a direct current voltage (V) to a series circuit of the memory element and a further capacity between the memory element ($R_A$, $R_B$, $C_A$, $C_B$) and the further capacity ($C_{out}$).

**7.** Method according to one of previous claims 3 to 6, **characterised in that** the drop of an alternating current voltage is measured through the memory element.

**8.** Memory element with at least a first stable state 0 and a second stable state 1, which may be converted to state 0 by applying a first writing voltage $V_0$ and to state 1 by applying a second writing voltage $V_1$, in which both states 0 and 1 manifest themselves in different electrical resistance values of the memory element on applying a reading voltage $V_R$ of a smaller amount than the writing voltages $V_0$ and $V_1$, in which the memory element has a circuit of at least two memory cells A and B, each having a stable state A0 or B0 and a stable state A1 or B1, **characterised in that**

• the circuit is an anti-series circuit of at least two resistive memory cells A and B, each having a stable state A0 or B0 with higher electrical resistance ($R_{off}$) and a stable state A1 or B1 with lower electrical resistance ($R_{on}$); and
• the capacities of the memory cells A and B differ from each other in the combination of states A0 and B0 and/or in the combination of states A1 and B1 by at least 10%.

**9.** Memory element according to claim 8, **characterised in that** it is made as a stack of a first metal electrode, a first layer of active material with variable electrical resistance, a second metal electrode, a further layer of active material with variable electrical resistance and a third metal electrode.

**10.** Memory element according to claim 9, **characterised in that** both layers of active material differ from each other in their thickness by at least a factor of 1.1.

**11.** Memory element according to one of claims 9 to 10, **characterised in that** both layers of active material differ from each other in their dielectric constant by at least a factor of 1.1.

**Revendications**

**1.** Procédé de lecture d'un élément de mémoire, qui comprend un montage d'au moins deux cellules de mémoire A et B, qui présentent chacune un état stable A0 ou B0 et un état stable A1 ou B1, l'état 0 de l'élément de mémoire étant codé dans la combinaison des états A1 et B0 et l'état 1 de l'élément de mémoire étant codé dans la combinaison des états A0 et B1, durant la lecture aucune des cellules de mémoire A et B n'étant commutée dans un autre état, **caractérisé en ce que**

- un élément de mémoire qui présente un montage anti-série d'au moins deux cellules de mémoire résistives A et B est choisi, lesquelles présentent chacune un état stable A0 ou B0 avec une forte résistance électrique ($R_{off}$) et un état stable A1 ou B1 avec une faible résistance électrique ($R_{on}$),
- la lecture l'élément de mémoire est effectuée par une mesure d'une grandeur électrique du montage de cellules de mémoire anti-série, et
- pour cela, une grandeur électrique est choisie, pour laquelle la cellule de mémoire A à l'état A0 apporte une autre contribution que la cellule de mémoire B à l'état B0 et/ou pour laquelle la cellule de mémoire A à l'état A1 apporte une autre contribution que la cellule de mémoire B à l'état B1.

**2.** Procédé selon la revendication 1, **caractérisé en ce qu'**une tension électrochimique générée par l'élément de mémoire est choisie en tant que grandeur électrique.

**3.** Procédé selon la revendication 1, **caractérisé en ce que** la capacité de l'élément de mémoire ($R_A$, $R_B$, $C_A$, $C_B$) est choisie en tant que grandeur électrique.

**4.** Procédé selon la revendication 3, **caractérisé en ce que** la constante de temps avec laquelle la capacité est chargée ou déchargée est évaluée.

5. Procédé selon l'une quelconque des revendications 3 à 4, **caractérisé en ce que** la courbe temporelle du courant ($V_{mess}/R_{reihe}$) qui est mis en circulation à travers l'élément de mémoire après l'application d'une tension continue sur l'élément de mémoire est mesurée.

6. Procédé selon l'une quelconque des revendications précédentes 3 à 5, **caractérisé en ce que** la courbe temporelle du potentiel ($V_{mess}$) qui est présent après l'application d'une tension continue (V) sur un montage série composé de l'élément de mémoire et d'une autre capacité entre l'élément de mémoire ($R_A$, $R_B$, $C_A$, $C_R$) et l'autre capacité ($C_{out}$) est mesurée.

7. Procédé selon l'une quelconque des revendications précédentes 3 à 6, **caractérisé en ce que** la chute d'une tension alternative aux bornes de l'élément de mémoire est mesurée.

8. Elément de mémoire avec au moins un premier état stable 0 et un second état stable 1, qui peut être passé par application d'une première tension d'écriture $V_0$ à l'état 0 et par application d'une seconde tension d'écriture $V_1$ à l'état 1, les deux états 0 et 1 se manifestant lors de l'application d'une tension de lecture $V_R$, qui a une valeur inférieure à celle des tensions d'écriture $V_0$ et $V_1$, par différentes valeurs de résistances électriques de l'élément de mémoire, l'élément de mémoire présentant un montage d'au moins deux cellules de mémoire A et B qui présentent chacune un état stable A0 ou B0 et un état stable A1 ou B1,
**caractérisé en ce que**

- le montage est un montage anti-série d'au moins deux cellules de mémoire résistives A et B, qui présentent chacune un état stable A0 ou B0 avec une forte résistance électrique ($R_{off}$) et un état stable A1 ou B1 avec une faible résistance électrique ($R_{on}$) ; et
- les capacités des cellules de mémoire A et B se différencient d'au moins 10 % dans la combinaison d'états A0 et B0 et/ou dans la combinaison d'états A1 et B1.

9. Elément de mémoire selon la revendication 8, **caractérisé en ce qu'**il est conçu sous forme d'un empilage d'une première électrode métallique, d'une première couche d'un matériau actif ayant une résistance électrique modifiable, d'une deuxième électrode métallique, d'une autre couche d'un matériau actif ayant une résistance électrique modifiable et d'une troisième électrode métallique.

10. Elément de mémoire selon la revendication 9, **caractérisé en ce que** les deux couches de matériau actif se différencient d'au moins un facteur 1,1 quant à leur épaisseur.

11. Elément de mémoire selon l'une quelconque des revendications précédentes 9 à 10, **caractérisé en ce que** les deux couches de matériau actif se différencient d'au moins un facteur 1,1 quant à leur constante diélectrique.

a.

Zustand 1

b.

Zustand 0

Figur 1

Figur 2

Figur 3

$$\frac{V_{mess}}{V} = \frac{11.8\,\text{fF}}{11.8\,\text{fF} + 100\,\text{fF}} = 0.106$$

$$\frac{V_{mess}}{V} = \frac{1.18\,\text{fF}}{1.18\,\text{fF} + 100\,\text{fF}} = 0.012$$

Figur 4

Figur 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009023153
- US 5729488 A